# EUROPÄISCHE PATENTSCHRIFT

(11) **EP 0 852 843 B1**
(45) Veröffentlichungstag und Bekanntmachung des Hinweises auf die Patenterteilung: **09.06.1999**
(21) Anmeldenummer: 96931795.7
(22) Anmeldetag: 12.09.1996
(51) Int. Cl.: H03B 9/14

(54) **HOHLLEITEROSZILLATOR**
WAVEGUIDE OSCILLATOR
OSCILLATEUR A GUIDE D'ONDES

(30) Priorität: 28.09.1995 DE 19536132
(43) Veröffentlichungstag der Anmeldung: 15.07.1998
(73) Patentinhaber: Daimler-Benz Aerospace Aktiengesellschaft, 81663 München (DE)
(72) Erfinder: RUST, Stefan, D-89250 Senden (DE)
(74) Vertreter: Fröhling, Werner Otto, Dr.
(86) Internationale Anmeldenummer: EP9604004
(87) Internationale Veröffentlichungsnummer: WO9712439

(56) Entgegenhaltungen:
- EP-A- 0 186 295
- DE-A- 3 808 251
- US-A- 4 890 074

## Beschreibung

Die Erfindung betrifft einen Hohlleiteroszillator für die Erzeugung von Grundwellen in einem Hohlleiter gemäß dem Oberbegriff des Patentanspruchs 1.

Bekannte Hohlleiteroszillatoren für die Erzeugung von Grundwellen in Hohlleitern bestehen aus einem in den Hohlleiter eingesetzten Pfosten, der als Sende-Antennenelement dient, und aus einem in den Hohlleiter eingesetzten Halbleiterschwingelement. Das Halbleiterschwingelement ist auf der Grundfläche des Hohlleiterinnenraumes angeordnet und der Pfosten ist zwischen der Gehäuseoberfläche des Halbleiterschwingelementes und der gegenüberliegenden Hohlleiterfläche eingesetzt, so daß er lotrecht stehend frei in den Hohlleiterinneraum abstrahlen kann. Als Halbleiterschwingelemente werden in den bekannten Hohlleiteroszillatoren gehäuste Gunn-Dioden, Impatt-Dioden oder ähnliche gehäuste Halbleiterelemente eingesetzt, die bei Anlegen einer Gleichspannung eine HF-Schwingung erzeugen können. Die Anpassung des Oszillators an den Wellenwiderstand des Hohlleiters erfolgt bei den bekannten Hohlleiteroszillatoren mittels eines Lambda-viertel-Kurzschlusses. Dieser Kurzschluß besteht aus einem einseitig geschlossenen Hohlleiterabschnitt, dessen Länge etwa ein Viertel der Wellenlänge der abzustrahlenden Grundwelle beträgt, und an dessen offenen Ende der Pfosten mit dem Halbleiterschwingelement angeordnet ist. Die bekannten Hohlleiteroszillatoren sind bedingt durch die Anfertigung und Montage der feinwerktechnischen Teile relativ teuer. Die Halbleiterschwingelemente in den bekannten Hohlleiteroszillatoren sind nur als gehäuste Elemente einsetzbar, da auf sie der Anpreßdruck des Pfostens einwirkt. Gehäuste Dioden sind aber ebenfalls sehr teuer im Vergleich zu ungehäusten Chip-Dioden.

Der Erfindung liegt die Aufgabe zugrunde einen kostengünstigen Hohlleiteroszillator zu schaffen, mit dem in einem Hohlleiter Grundwellen erzeugt werden können.

Diese Aufgabe wird erfindungsgemäß durch die im Patentanspruch 1 angegebenen Merkmale gelöst. Weiterbildungen der Erfindung sind in den Unteransprüchen angegeben.

Die Erfindung weist eine zu herkömmlichen Hohlleiteroszillatoren vergleichbare Frequenzstabilität auf, hat dabei jedoch einen größeren Oszillator-Wirkungsgrad. Die in den Hohlleiter ausgekoppelte HF-Leistung ist deshalb bei gleicher Gleichspannungsleistung größer. Es können preiswerte Chip-Dioden verwendet werden, da die Erfindung Bond-Verbindungen zwischen den Antenenelementen und den Dioden zuläßt.

Der erfindungsgemäße Oszillator eignet sich mit seiner planaren Schlitzleiterstruktur in vorteilhafter Weise für eine Massenproduktion, da diese Struktur ätztechnisch hergestellt werden kann. Die Einbautiefe des erfindungsgemäßen Oszillators kann in vorteilhafter Weise klein gehalten werden, da ein Lambda-viertel-Kurzschluß zur Impedanzanpassung nicht unbedingt erforderlich ist. Bei Bedarf ist gemäß einer Weiterbildung der Erfindung, die durch die Verwendung von zwei Halbleiterschwingelementen und einer Verdopplung der Antennenelemente gekennzeichnet ist, bei gleicher Einbautiefe eine Verdopplung der Oszillatorleistung möglich. Auch kann gemäß einer anderen Weiterbildung der Erfindung die Oszillatorleistung bei Verwendung nur eines Halbleiterschwingelementes vorteilhaft durch eine Verdopplung der Antennenelemente gesteigert werden, indem die zusätzlichen Antennenelemente anstelle des Halbleiterschwingelementes einen HF-Kurzschluß aufweisen. Die Weiterbildungen mit verdoppelten Antennenelementen eignen sich besonders für Hohlleiterschaltungen, da sie den Symmetrieeigenschaften des Hohlleiterfeldes entgegenkommen.

Anhand der Zeichnung werden Ausführungsbeispiele der Erfindung näher erläutert.
Fig.1 zeigt einen Hohlleiteroszilator mit einem Halbleiterschwingelement und mit randförmig angeordneten Schlitzleitern,
Fig.2 zeigt einen Hohlleiteroszillator mit zwei Halbleiterschwingelementen, bei dem die Kompensations-Schlitzleiter zentral angeordnet sind,
Fig.3 zeigt einen Hohlleiteroszillator entsprechend Fig.2, bei dem das zweite Halbleiterschwingelement durch HF-Kurzschlüsse ersetzt ist,
Fig.4 zeigt einen Hohlleiteroszillator entsprechend Fig.3, bei dem die HF-Kurzschlüsse mit nur einer Stichleitung gebildet sind,
Fig.5 zeigt einen Hohlleiteroszillator für einen Hohlleiter mit kreisförmigen Querschnitt und
Fig.6 zeigt das den erfindungsgemäßen Lösungen zugrundlegende Prinzip des Zusammenwirkens der Resonanzkurven von Antennen- und Kompensations-Schlitzleitern.

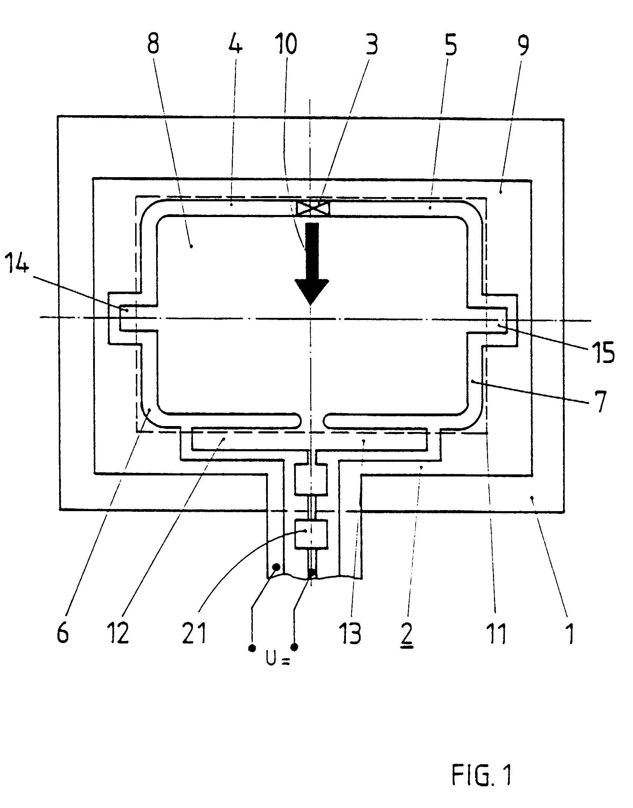

Fig.1 zeigt die Schlitzleiterstruktur 2 eines Hohlleiteroszillators für die Erzeugung von Grundwellen in einem Hohlleiter, die auf die Querschnittsfläche eines rechteckförmigen Hohlleiter 1 aufgesetzt ist. Die Schlitzleiterstrutur 2 ist in einer Metallschicht auf einem planaren, einseitig metallisierten, dielektrischen Substrat ausgebildet. In die Schlitzleiterstruktur 2 sind zwei Sende-Schlitzleiter 4 und 5, zwei Kompensations-Schlitzleiter 6 und 7, ein Halbleiterschwingelement 3, zwei kapazitive Elemente 14 und 15, zwei Stichleitungen 12 und 13 und ein Tiefpaß 21 integriert.

Die Sende-Schlitz leiter 4 und 5 sind mit offenen Enden hintereinander geschaltet und an der Zusammenfügungsstelle von einem ungehäusten Halbleiterschwingelement 3 überbrückt. Das verwendete Halbleiterschwingelement 3 erzeugt bei Anlegen einer Gleichspannung HF-Energie und kann je nach Anwendungsfall eine Gunn-Diode, eine Impatt-Diode oder eine ähnlich wirkendende HF-Diode sein. Das Halbleiterschwingelement 3 ist mittels Bondverbindungen in die Schlitzleiterstruktur 2 integriert. Das Halbleiterschwingelement 3 und die Sende-Schlitz leiter 4 und 5 sind in der Schlitzleiterstruktur 2 so angeordnet, daß das Halbleiterschwingelement dem Fußpunkt des maximalen Feldstärkevektors 10 des angrenzenden Hohlleiter-E-feldes benachbart ist.

Die beiden Sende-Schlitzleiter 4,5 sind gleich ausgebildet, besitzen somit dieselbe Resonanzfrequenz f(ind OI), und sind in der Schlitzleiterstruktur 2 so angeordnet, daß sie auf ihrer gesamten Länge mit ihrer Außenkante an die Umrandung des Hohlleiterinnenraumes 11 grenzen. Ihre elektrisch wirksame Länge beträgt jeweils eine halbe Wellenlänge der zu erzeugenden Grundwelle. An ihren nicht zusammengeschalteten Enden sind die Sende-Schlitzleiter 4,5 jeweils mit einem kapazitiven Elementen 14,15 nahezu kurzgeschlossen. Die kapazitiven Elemente 14 und 15 sind außerhalb der Umrandung des Hohlleiterinnenraumes 11 angeordnet.

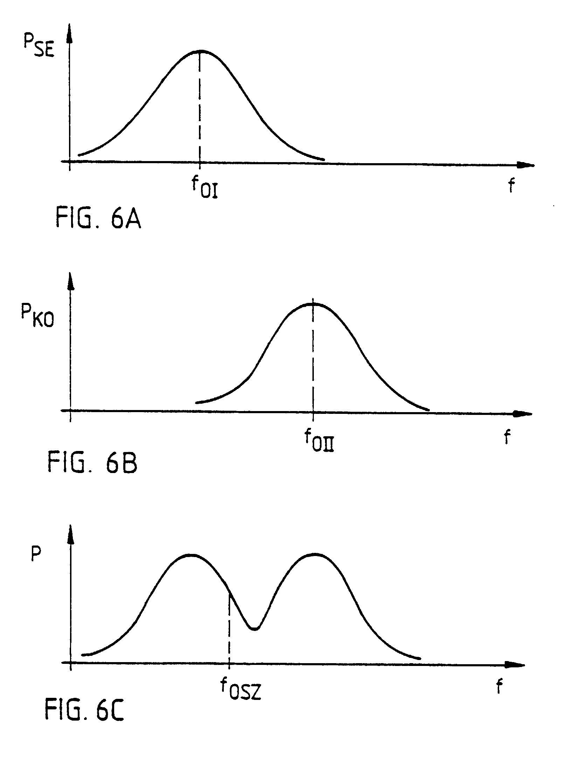

An die kurzgeschlossenen Enden der Sende-Schlitzleiter 4,5 schließt sich jeweils ein Kompensations-Schlitzleiter 6,7 an. Die die Sende-Schlitzleiter 4,5 kurzschließenden kapazitiven Elemente 14,15 bilden an den Anschlußstellen für die Kompensations-Schlitzleiter 6,7 ebenfalls einen Kurzschluß. Auch die Kompensations-Schlitzleiter 6,7 grenzen mit ihrer Außenkante an die Umrandung des Hohlleiterinnenraumes 11, sind gleich ausgebildet und besitzen dieselbe Resonanzfrequenz f(ind OII). Die Länge der Kompensations-Schlitzleiter 6,7 beträgt jeweils ungefähr der halben Wellenlänge der zu erzeugenden Grundwelle. Ihre elektrisch wirksame Länge und damit die Resonanzfrequenz f(ind OII) ist aber jeweils durch eine transformierende Stichleitung 12,13 bestimmt, welche die anderen Enden der Kompensations-Schlitzleiter 6,7 abschließt. Diese transformierenden Stichleitungen 12,13 sind außerhalb der Umrandung des Hohlleiterinnenraumes 11 in der Schlitzleiterstruktur 2 angeordnet. Die Resonanzfrequenzen f(ind OII) der Kompensations-Schlitzleiter 6,7 sind gem. Fig.6 in bezug auf die Resonanzfrequenzen f(ind OI) der Sende-Schlitzleiter 4,5 so eingestellt, daß die im Bereich des Halbleiterschwingelementes und dem Hohlleiter 1 erzeugte Blindleistung kompensiert wird und eine optimale Impedanz-Anpassung zwischen Hohlleiter und Oszillator erreicht ist.

In der Schlitzleiterstruktur 2 ist durch die Schlitzleiter 4,5,6,7 eine innere Leiterfläche 8 und eine äußere Leiterfläche 9 voneinander getrennt. Die Versorgungs-Gleichspannung für das Halbleiterschwingelement 3 wird dem Element über diese Leiterflächen zugeführt. Dazu ist in die Schichtleiterstruktur 2 ein Mikrostreifen-Tiefpaß 21 integriert, der galvanisch getrennt von der äußeren Leiterfläche 9 die innere Leiterfläche 8 kontaktiert.

Die Schlitzleiterstruktur 2 ist mit ihrer äußeren Leiterfläche 9 in eine passende Vertiefung der Querschnittsfläche des Hohlleiters 1 eingelötet. Eine Befestigung der Schichtleiterstruktur mittels Klebetechnik ist ebenfalls möglich. Auch kann in einer abgewandelten Form die Schichtleiterstruktur 2 über die äußere Umrandung des Hohlleiters 1 beliebig hinausragen.

Da das Halbleiterschwingelement 3 zwei als Resonatoren wirkende Schlitzleiter speist und die erzeugte Blindleistung ebenfalls mit zwei als Resonatoren wirkende schlitzleitungen kompensiert wird, besitzt der Hohlleiteroszillator eine hohe Phasensteilheit und damit eine gute Frequenzstabilität. Aufgrund der geringen Entfernung der Kompensations-schlitzleiter vom Halbleiterschwingelement ist das Schwingverhalten des Hohlleiteroszillators eindeutig. Fig.6c zeigt die Lage der Oszillator-Frequenz f(ind OSZ), z.B. eines Gunn-Oszillators, im Bereich der größten Phasensteilheit der erfindungsgemäßen Oszillatorschaltung. Die Schaltung besitzt bei dieser Frequenz noch Blindleistung, welche zur Kompensation der Blindleistung des Halbleiterschwingelementes dient.

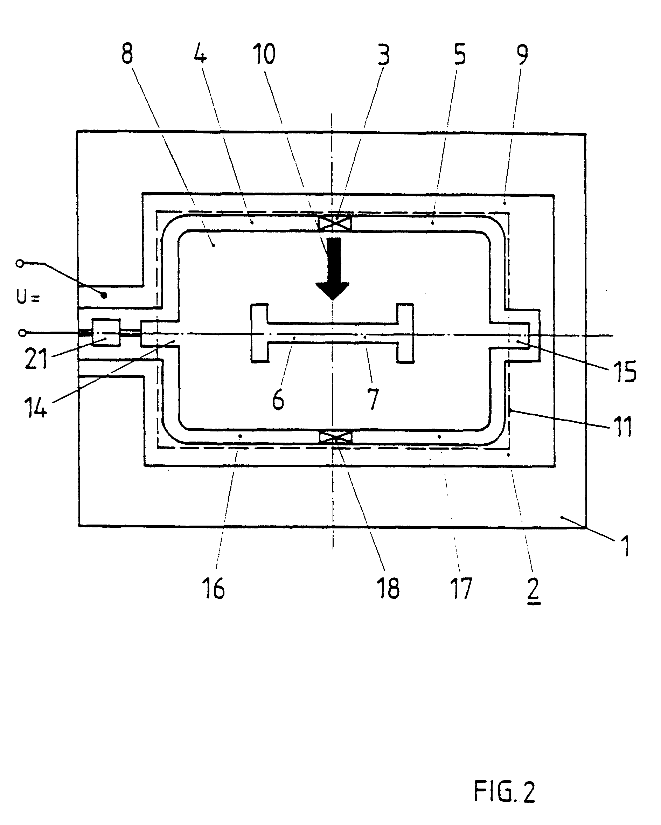

Fig.2 zeigt einen Hohlleiteroszillator mit einer gegenüber der in Fig.1 gezeigten Ausführung Vergrößerung der Oszillatorleistung, die mit einer Verdopplung des Sende-Schlitzleitersystemes und einem zusätzlichen Halbleiterschwingelement 18 erreicht wird. Die beiden Halbleiter- und Sende-Schlitzleitersysteme sind identisch aufgebaut und in der Schlitzleiterstruktur 2 spiegel-symmetrisch zueinander angeordnet, so daß ein Halbleiterschwingelement 3 dem Fußpunkt des maximalen Feldstärkevektors 10 des angrenzenden Hohlleiter-E-Feldes benachbart ist und das andere Halbleiterschwingelement 18 dem ersten Halbleiterschwingelement 3 gegenüberliegend angeordnet ist. Alle Schlitzleiter weisen jeweils eine elektrisch wirksame Länge von einer halben Wellenlänge der zu erzeugenden Grundwelle auf und sind mit ihren Außenkanten der Umrandung des Hohlleiterinnenraumes benachbart angeordnet. Die beiden Schlitzleitersysteme sind an ihren den Halbleiterschwingelementen abgewandten Enden jeweils mittels eines kapazitiven Elementes 14,15 nahezu kurzgeschlossen. Diese Elemente entsprechen in ihrer Ausführung den in Fig.1 beschriebenen Elementen. Die Gleichspannungszuführung zu den Halbleiterschwingelementen 3,18 erfolgt über einen Tiefpaß 21, der in diesem Ausführungsbeispiel seitlich an eines der kapazitiven Elemente 14,15 angekoppelt ist. Diese Tiefpaßanordnung könnte alternativ auch in dem mit Fig.1 gezeigtem Ausführungsbeispiel verwendet werden.

Die Kompensation der von den Sende-Schlitzleitern erzeugten Blindleistungen erfolgt mittels zwei Kompensations-Schlitzleitern 6,7, die mit ihren offenen Enden zusammen geschaltet sind. Die anderen Enden stellen einen Kurzschluß dar und sind so ausgebildet, daß die zusammengeschalteten Kompensations-Schlitzleiter die Form einer H-Blende bilden. Alternativ kannen auch eine andere Form für die Kompensationsschlitzleiter 6,7 zur Anwendung kommen. Die H-Blende ist in der Schlitzleiterstruktur 2 zentral so angeordnet, daß ihr Mittelstück lotrecht auf dem maximalen Feldstärkevektor 10 steht. Die Resonanzfrequenz der Kompensations-Schlitzleiter 6,7 ist abweichend von der Resonanzfrequenz der Sende-Schlitzleiter 4,5,16,17 eingestellt, damit die in den Hohlleiter abgestrahlte Blindleistung der Sende-Schlitzleiter im Hohlleiter 1 kompensiert wird.

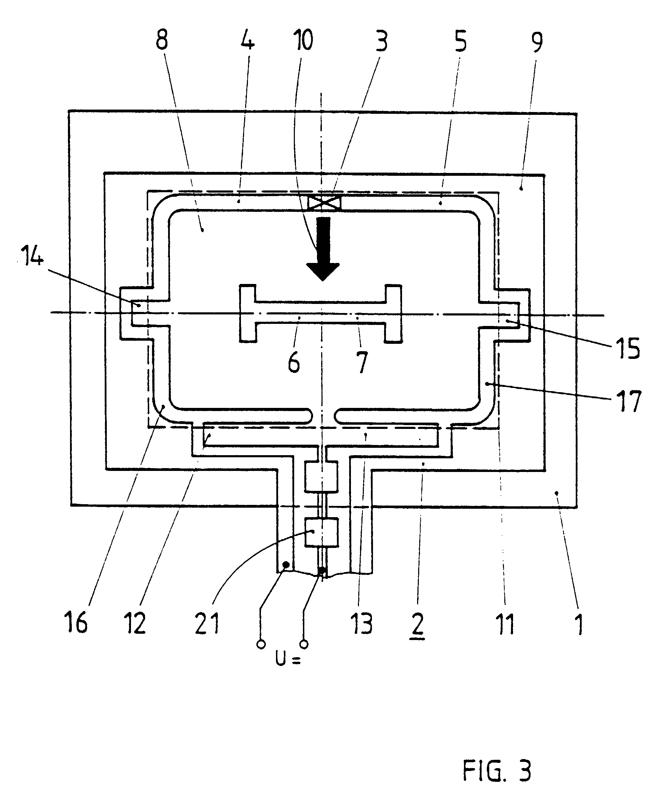

Der in Fig.3 gezeigte Hohlleiteroszillator entspricht in seinem grundsätzlichen Aufbau mit dem verdoppelten Sende-Schlitzleitersystem und der zentral angeordneten H-Blende dem in Fig.2 gezeigtem Ausführungsbeispiel. Abweichend zu der dort gezeigten Ausführung ist hier auf das zweite Halbleiterschwingelement 18 verzichtet. Dafür ist zwischen den diesbezüglichen Schlitzleiterenden ein transformatorisch hergestellter HF-Kurzschluß angeordnet. Dieser Kurzschluß besteht aus Stichleitungen 12,13, die eine elektrisch wirksame Länge von einem Viertel der zu erzeugenden Grundwelle aufweisen und von der äußeren Leiterfläche 9 galvanisch getrennt sind. Die elektrischen Feldverteilungen auf den Sende-Schlitzleitern 16,17 entsprechen den Feldverteilungen der vorangehend beschriebenen Ausführungsvariante mit dem zweiten Halbleiterschwingelement 18. Der Tiefpaß 21 für diese Ausführungsvariante ist an den HF-Kurzschluß angekoppelt, könnte aber auch an eines der kapazitiven Elemente 14,15 angebunden sein.

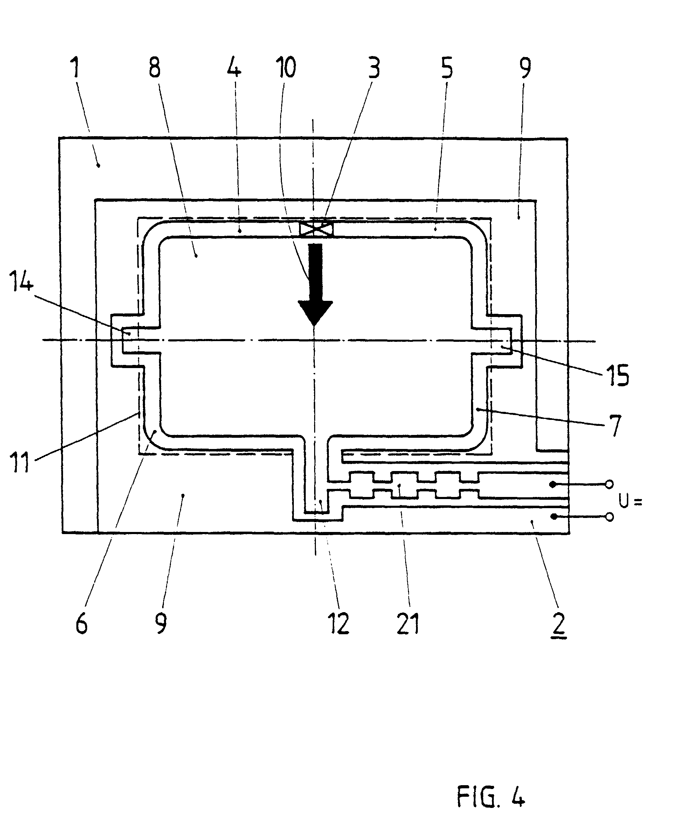

Eine einfachere Ausführung des HF-Kurzschlusses zeigt Fig.4, wobei nur eine Stichleitung 12 wirksam ist, was nur eine geringfügige Verschlechterung der Oszillatorwirkung im Vergleich mit dem in Fig.4 gezeigtem Ausführungsbeispiel zur Folge hat.

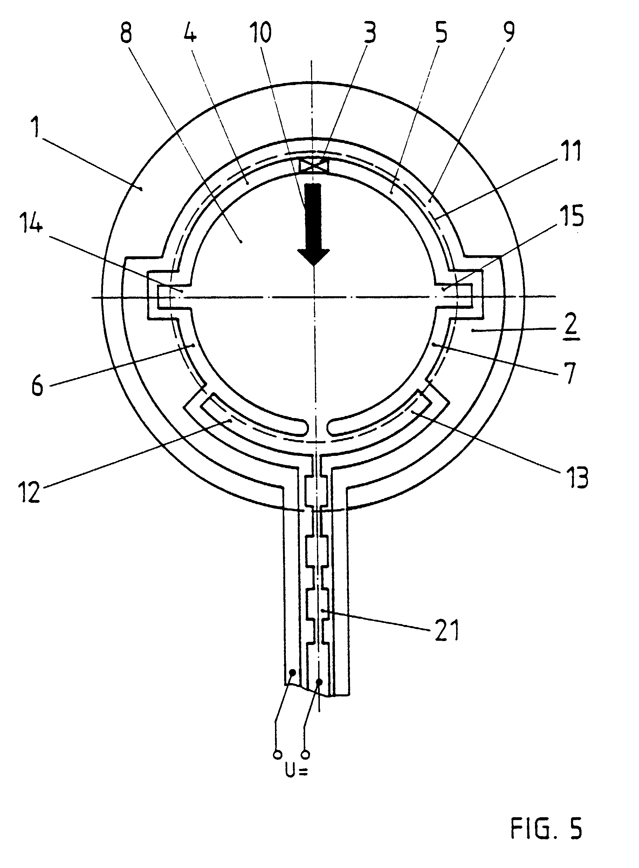

Fig.5 zeigt ein Ausführungsbeispiel gemäß Fig.1, das in Abweichung dazu für einen Hohlleiter 1 mit kreisförmigem Querschnitt ausgebildet ist, in seinem grundsätzlichen Aufbau aber dem voranstehend zu Fig.1 gemachten Ausführungen vollständig entspricht. Wichtig ist, daß das Halbleiterschwingelement 3 dem Fußpunkt des maximalen Feldstärkevektors 10 benachbart ist. In der in Fig.5 gezeigten Weise sind auch die in den Figuren 2 bis 4 gezeigten Ausführungsbeispiele auf kreisförmige Hohlleiter übertragbar.

Die Figuren 6a bis 6c zeigen Blindleistungs-Resonanzkurven des Hohlleiteroszillators. In Fig.6a ist die abgestrahlte Blindleistung der Sende-Schlitzleiter P(ind SE) aufgetragen. Fig.6b zeigt die Blindleistung der Kompensations-Schlitzleiter P(ind KO) und Fig.6c die sich überlagernden Blindleistungen in der Gesamtschaltung P. Die Frequenz f(ind OSZ) entspricht der Freqeunz mit der die Halbleiterschwingelemente 3,18 in den erfindungsgemäßen Schaltungen betrieben werden.

Die Wirkung der Kompensations-Schlitzleiter 6,7 läßt sich in sämtlichen der voranstehnd beschriebenen Ausführungsbeispiele dadurch erhöhen, daß die Schlitzleiterstrukur 2 in einem Lambda-viertel-Abstand von einem kurzgeschlossenen Ende des Hohlleiters 1 eingesetzt ist. Die an diesem Lambda-viertel-Kurzschluß reflektierten Hf-Anteile tragen mit zur Kompensation der von den Sende-Schlitzleitern abgestrahlten Blindleistungen bei.

## Patentansprüche

1. Hohlleiteroszillator für die Erzeugung von Grundwellen in einem Hohlleiter mit mindestens einem Halbleiterschwingelement und mit mindestens einem Sende-Antennenelement in dem Hohlleiter, dadurch gekennzeichnet, daß der Grundwellenoszillator als eine planare Schlitzleiterstruktur (2) ausgebildet ist, daß die Schlitzleiterstruktur (2) in einer Querschnittsfläche des länglichen Hohlleiters (1) in etwa lotrecht zur Hohlleiterachse angeordnet ist, daß die Schlitzleiterstruktur (2) zwei mit ihren offenen Enden hintereinandergeschaltete Sende-Schlitzleiter (4,5) aufweist, daß das Halbleiterschwingelement (3) in die Schlitzleiterstruktur (2) integriert ist und die zusammengeschalteten offenen Enden der Sende-Schlitzleiter (4,5) überbrückt, daß die Sende-Schlitzleiter (4,5) in ihrer Resonanzfrequenz f(ind OI) übereinstimmen, daß die Schlitzleiterstruktur (2) mindestens einen Kompensations-Schlitzleiter (6,7) aufweist, daß die Resonanzfrequenz f(ind OII) der Kompensationsschlitzleiter (6,7) von der Resonanzfrequenz f(ind OI) der Sende-Schlitzleiter (4,5) abweicht und daß dem Halbleiterschwingelement über eine innere Leiterfläche (8) und eine äußere Leiterfläche (9), die in der Schlitzleiterstruktur (2) galvanisch voneinander getrennt sind, die Gleichspannungsversorgung zugeführt ist.

2. Hohlleiteroszillator nach Anspruch 1, dadurch gekennzeichnet, daß das die offenen Enden der Sende-Schlitzleiter (4,5) überbrückende Halbleiterschwingelement (3) in der Schlitzleiterstruktur (2) an der Stelle angeordnet ist, an der es dem Fußpunkt des maximalen Feldstärkevektors (10) des angrenzenden Hohlleiter-E-Feldes benachbart ist.

3. Hohlleiteroszillator nach Anspruch 1 oder 2, dadurch gekennzeichnet, daß die elektrisch wirksame Länge der Sende-Schlitzleiter (4,5) jeweils eine halben Wellenlänge der zu erzeugenden Grundwelle beträgt.

4. Hohlleiteroszillator nach einem der Ansprüche 1 bis 3, dadurch gekennzeichnet, daß die Sende-Schlitzleiter (4,5) auf ihrer gesamten Länge mit ihrer Außenkante in etwa an die Umrandung des Hohlleiterinnenraumes (11) angrenzen.

5. Hohlleiteroszillator nach einem der Ansprüche 1 bis 4, dadurch gekennzeichnet, daß die Schlitzleiterstruktur (2) zwei gleichartig ausgebildete Kompensations-Schlitzleiter (6,7) aufweist, deren offene Enden zusammengeschaltet sind.

6. Hohlleiteroszillator nach Anspruch 5, dadurch gekennzeichnet, daß die Kompensations-Schlitzleiter (6,7) auf ihrer gesamten Länge in etwa mit ihrer Außenkante an die Umrandung des Hohlleiterinnenraumes (11) angrenzen, daß der Zusammenfügungspunkt der offenen Enden der Kompensations-Schlitzleiter (6,7) gegenüber dem Halbleiterschwingelement (3) angeordnet ist und daß die Resonanzfrequenz f(ind OII) der Kompensations-Schlitzleiter (6,7) jeweils mittels einer Stichleitung (12,13) elektrisch abgestimmt ist und daß die Stichleitungen (12,13) außerhalb der Umrandung des Hohlleiterinnenraumes (11) in die Schlitzleiterstruktur (2) integriert sind.

7. Hohlleiteroszillator nach Anspruch 5 oder 6, dadurch gekennzeichnet, daß die nicht zusammengeschalteten Enden der jeweils zusammenwirkende Sende-Schlitz leiter und Kompensations-Schlitzleiter (4 und 6, 5 und 7) ineinander übergehen, daß sie an der Übergangsstelle jeweils mittels eines in der Schlitzleiterstruktur (2) ausgebildeten kapazitiven Elementes (14,15) gegeneinander kurzgeschlossen sind und daß die kapazitiven Elemente in der Schlitzleiterstruktur (2) außerhalb der Umrandung des Hohleiterinnenraumes (11) ausgebildet sind.

8. Hohlleiteroszillator nach Anspruch 5, dadurch gekennzeichnet, daß die zusammengeschalteten Kompensations-Schlitzleiter (6,7) ungefähr Lambda-viertel lang und kurzgeschlossene Schlitz leiter sind, die zentral und lotrecht zu den Vektoren des angrenzenden Hohlleiter-E-Feldes angeordnet ist.

9. Hohlleiterabschnitt nach Anspruch 8, dadurch gekennzeichnet, daß die zusammengeschalteten Kompensationschlitzleiter (6,7) als H-Blende ausgebildet sind.

10. Hohlleiteroszillator nach Anspruch 8 oder 9, dadurch gekennzeichnet, daß die Schlitzleiterstruktur (2) zwei zusätzliche Sende-Schlitzleiter (16,17)
aufweist, die auf der gesamten Länge mit ihrer Außenkante in etwa an die Umrandung des Hohlleiterinnenraumes (11) angrenzen und die in ihrer Resonanzfrequenz mit der Resonanzfrequenz f(ind OI) der ersten beiden Sende-Schlitzleiter (4,5) übereinstimmen.

11. Hohlleiteroszillator nach Anspruch 10, dadurch gekennzeichnet, daß die beiden zusätzlichen Sende-Schlitzleiter (16,17) mit offenen Enden zusammengeschaltet und an der Zusammenfügungstelle von einem Halbleiterschwingelement (18) überbrückt sind, das in die Schlitzleiterstruktur (2) dem Halbleiterschwingelement (3) gegenüberliegend integriert ist.

12. Hohlleiteroszillator nach Anspruch 11, dadurch gekennzeichnet, daß die auf gleichen Seiten der Halbleiterschwingelemente (3,18) angeordneten Sende-Schlitzleiter (4 und 16, 5 und 17) jeweils durch ein in der Schlitzleiterstruktur (2) ausgebildetes kapazitives Element (15,16) gegeneinander kurzgeschlossen sind und daß die kapazitiven Elemente außerhalb der Umrandung des Hohlleiterinnenraumes (11) angeordnet sind.

13. Hohlleiteroszillator nach Anspruch 10, dadurch gekennzeichnet, daß die zusätzliche Sende-Schlitzleiter (16,17) an einem Ende jeweils einen HF-Kurzschluß (19,20) aufweisen und daß die mit den HF-Kurzschlüssen (19,20)versehenen Enden der Sende-Schlitzleiter (16,17) gegenüberliegend zum Halbleiterschwingelement (3) angeordnet sind.

14. Hohlleiteroszillator nach Anspruch 13, dadurch gekennzeichnet, daß die auf gleichen Seiten des Halbleiterschwingelementes (3) angeordneten Sende-Schlitzleiter (4 und 16, 5 und 17) jeweils durch ein in der Schlitzleiterstruktur (2) ausgebildetes kapazitives Element (15,16) gegeneinander kurzgeschlossen sind und daß die kapazitiven Elemente außerhalb der Umrandung des Hohlleiterinnenraumes (11) angeordnet sind.

15. Hohlleiteroszillator nach einen der Ansprüche 10 bis 14, dadurch gekennzeichnet, daß die Sende-Schlitzleiter (4,5,16,17) jeweils eine elektrisch wirksame Länge aufweisen, die einer halben Wellenlänge der im Hohlleiter zu erzeugenden Grundwelle entspricht.

16. Hohlleiteroszillator nach einen der Ansprüche 10 bis 15, dadurch gekennzeichnet, daß der Hohlleiter (1) auf einer Seite der in den Hohlleiter (1) eingesetzten Schlitzleiterstruktur (2) einen Lambda-viertel- Kurzschluß aufweist und daß die Schlitzleiterstruktur (2) die Grundwelle auf der anderen Seite in einen weiterführenden Abschnitt des Hohlleiters (1) einspeist.

17. Hohlleiteroszillator nach einen der Ansprüche 1 bis 16, dadurch gekennzeichnet, daß der lotrecht zur Hohlleiterachse liegende Querschnitt des Hohlleiters (1) rechteckförmig ist.

18. Hohhleiteroszillator nach einen der Ansprüche 1 bis 16, dadurch gekennzeichnet, daß der lotrecht zur Hohlleiterachse liegende Querschnitt des Hohlleiters (1) kreisförmig ist.

## Claims

1. Waveguide oscillator for generation of fundamental waves in a waveguide with at least one semiconductor oscillator element and at least one transmission antenna element in the waveguide, characterised thereby that the fundamental wave oscillator is constructed as a planar slotted guide structure (2), that the slotted guide structure (2) is arranged in a cross-sectional plane of the elongate waveguide (1) approximately perpendicularly to the waveguide axis, that the slotted guide structure (2) has two transmission slotted guides (4, 5) connected one behind the other by their open ends, that the semiconductor oscillator element (3) is integrated in the slotted guide structure (2) and bridges over the interconnected open ends of the transmission slotted guides (4, 5), that the transmission slotted guides (4, 5) correspond in their resonance frequency f (ind Ol), that the slotted guide structure (2) has at least one compensating slotted guide (6, 7), that the resonance frequency f (ind OII) of the compensating slotted guides (6, 7) differs from the resonance frequency f (ind OI) of the transmission slotted guides (4, 5) and that the direct voltage supply is fed to the semiconductor oscillator element by way of an inner guide surface (8) and an outer guide surface (9) which are electrically separated from one another in the slotted guide structure (2).

2. Waveguide oscillator according to claim 1, characterised thereby that the semiconductor oscillator element (3) bridging over the open ends of the transmission slotted guides (4, 5) is arranged in the slotted guide structure (2) at the place at which it is adjacent to the foot of the maximum field strength vector (10) of the adjoining waveguide E field.

3. Waveguide oscillator according to claim 1 or 2, characterised thereby that the electrically effective length of the transmission slotted guides (4, 5) each time amounts to half the wavelength of the fundamental wave to be generated.

4. Waveguide oscillator according to one of claims 1 to 3, characterised thereby that the transmission slotted guides (4, 5) approximately adjoin the boundary of the waveguide cavity (11) over their entire length by their outer edge.

5. Waveguide oscillator according to one of claims 1 to 4, characterised thereby that the slotted waveguide structure (2) comprises two identically constructed compensating slotted guides (6, 7), the open ends of which are connected together.

6. Waveguide oscillator according to claim 5, characterised thereby that the compensating slotted guides (6, 7) adjoin the boundary of the waveguide cavity (11) over their entire length approximately by their outer edge, that the joining point of the open ends of the compensating slotted guides (6, 7) is arranged opposite the semiconductor oscillator element (3), that the resonance frequency f (ind OII) of the compensating slotted guides (6, 7) is electrically matched each time by a matching conductor (12, 13) and that the matching conductors (12, 13) are integrated in the slotted guide structure (2) outside the boundary of the waveguide cavity (11).

7. Waveguide oscillator according to claim 5 or 6, characterised thereby that the ends, which are not connected together, of the respective co-operating transmission slotted guides and compensating slotted guides (4 and 6, 5 and 7) go over one into the other, that they are short-circuited relative to one another at the transition location each time by means of a capacitive element (14, 15) formed in the slotted guide structure (2) and that the capacitive elements are formed in the slotted guide structure (2) outside the boundary of the waveguide cavity (11).

8. Waveguide oscillator according to claim 5, characterised thereby that the interconnected compensating slotted guides (6, 7) are approximately quarter lambda long and are a short-circuited slotted guide, which is arranged centrally and perpendicularly to the vectors of the adjoining waveguide E field.

9. Waveguide oscillator according to claim 8, characterised thereby that the interconnected compensating slotted guides (6, 7) are formed as an H aperture.

10. Waveguide oscillator according to claim 8 or 9, characterised thereby that the slotted guide structure (2) comprises two additional transmission slotted guides (16, 17), which approximately adjoin the boundary of the waveguide cavity (11) over the entire length by their outer edges and which correspond in their resonance frequency with the resonance frequency f (ind OI) of the first two transmission slotted guides (4, 5).

11. Waveguide oscillator according to claim 10, characterised thereby that the two additional transmission slotted guides (16, 17) are connected together at open ends and are bridged over at the joint location by a semiconductor oscillator element (18), which is integrated in the slotted guide structure (2) to lie opposite the semiconductor oscillator element (3).

12. Waveguide oscillator according to claim 11, characterised thereby that the transmission slotted guides (4 and 16, 5 and 17) which are arranged on the same sides of the semiconductor elements (3, 18) are each time short-circuited relative to one another by a capacitive element (15, 16) formed in the slotted guide structure (2) and that the capacitive elements are arranged outside the boundary of the waveguide cavity (11).

13. Waveguide oscillator according to claim 10, characterised thereby that the additional transmission slotted guides (16, 17) have a respective high-frequency short circuit (19, 20) at one end and that the ends, which are provided with the high-frequency short circuits (19, 20), of the transmission slotted guides (16, 17) are arranged opposite the semiconductor oscillator element (3).

14. Waveguide oscillator according to claim 13, characterised thereby that the transmission slotted guides (4 and 16, 5 and 17) arranged on the same sides of the semiconductor oscillator element (3) are each time short-circuited relative to one another by a capacitive element (15, 16) formed in the slotted guide structure (2) and that the capacitive elements are arranged outside the boundary of the waveguide cavity (11).

15. Waveguide oscillator according to one of claims 10 to 14, characterised thereby that transmission slotted guides (4, 5, 16, 17) each have an electrically effective length which corresponds to half the wave length of the fundamental wave to be generated in the waveguide.

16. Waveguide oscillator according to one of claims 10 to 16, characterised thereby that the waveguide (1) has a quarter-lambda short circuit on one side of the slotted guide structure (2) inserted in the waveguide (1) and that the slotted guide structure (2) feeds the fundamental wave on the other side into a continuing section of the waveguide (1).

17. Waveguide oscillator according to one of claims 1 to 16, characterised thereby that the cross-section of the waveguide (1) extending perpendicularly to the waveguide axis is rectangular.

18. Waveguide oscillator according to one of claims 1 to 16, characterised thereby that the cross-section of the waveguide (1) extending perpendicularly to the waveguide axis is circular.

## Revendications

1. Oscillateur à guide d'ondes pour la production d'ondes fondamentales dans un guide d'ondes, comportant au moins un élément oscillant à semiconducteur et au moins un élément d'antenne émettrice dans le guide d'ondes, caractérisé par le fait que l'oscillateur pour ondes fondamentales est conçu sous forme d'une structure plane de conducteur à fente (2), que la structure de conducteur à fente (2) est disposée dans une surface de coupe du guide d'ondes longitudinal (1), à peu près perpendiculairement à l'axe du guide d'ondes, que la structure de conducteur à fente (2) présente deux conducteurs à fente rayonnante (4, 5) mis en circuit l'un derrière l'autre par leurs extrémités ouvertes, que l'élément oscillant à semiconducteur (3) est intégré dans la structure de conducteur à fente (2) et ponte les extrémités ouvertes, mises en circuit ensemble, des conducteurs à fente rayonnante (4, 5), que les conducteurs à fente rayonnante (4, 5) coïncident en ce qui concerne leur fréquence de résonance f (désignée OI), que la structure de conducteur à fente (2) présente au moins un conducteur à fente de compensation (6, 7), que la fréquence de résonance f (désignée OII) des conducteurs à fente de compensation (6, 7) s'écarte de la fréquence de résonance f (désignée OI) des conducteurs à fente rayonnante (4, 5) et que l'alimentation en tension continue est amenée à l'élément oscillant à semiconducteur par l'intermédiaire d'une surface conductrice intérieure (8) et d'une surface conductrice extérieure (9) qui sont galvaniquement séparées l'une de l'autre dans la structure de conducteur à fente (2).

2. Oscillateur à guide d'ondes selon la revendication 1, caractérisé par le fait que l'élément oscillant à semiconductcur (3) qui ponte les extrémités ouvertes des conducteurs à fente rayonnante (4, 5) est disposé, dans la structure de conducteur à fente (2), à l'emplacement où il est voisin du pied du vecteur d'intensité de champ maximal (10) du champ électrique E du guide d'ondes qui le jouxte.

3. Oscillateur à guide d'ondes selon la revendication 1 ou 2, caractérisé par le fait que la longueur électriquc efficace de chacun des conducteurs à fente rayonnante (4, 5) vaut une demi-longueur de l'onde fondamentale à produire.

4. Oscillateur à guide d'ondes selon l'une des revendications 1 à 3, caractérisé par le fait que, sur toute leur longueur, les conducteurs à fente rayonnante (4, 5) viennent, par leur bord extérieur, à peu près en bordure de l'espace intérieur (11) du guide d'ondes.

5. Oscillateur à guide d'ondes selon l'une des revendications 1 à 4, caractérisé par le fait que la structure de conducteur à fente (2) présente deux conducteurs à fente de compensation (6, 7), de conception identique dont les extrémités ouvertes sont reliées ensemble.

6. Oscillateur à guide d'ondes selon la revendication 5, caractérisé par le fait que, sur toute leur longueur, les conducteurs à fente de compensation (6, 7) viennent à peu près, par leur bord extérieur, en bordure de l'espace intérieur (11) du guide d'ondes, que l'emplacement du joint des extrémités ouvertes des conducteurs à fente de compensation (6, 7) est disposé en face de l'élément oscillant à semiconducteur (3) et que la fréquence de résonance f (désignée OII) de chacun des conducteurs à fente de compensation (6, 7) est électriquement accordée au moyen d'un adaptateur d'impédance (12, 13) et que les adaptateurs d'impédance (12, 13) sont intégrés dans la structure de conducteur à fente (2), à l'extérieur de la bordure de l'espace intérieur (11) du guide d'ondes.

7. Oscillateur à guide d'ondes selon la revendication 5 ou 6, caractérisé par le fait que les extrémités non reliées ensemble des conducteurs à fente rayonnante et des conducteurs à fente de compensation (4 et 6, 5 et 7) qui collaborent respectivement se convertissent l'une dans l'autre, qu'à leur emplacement de conversion, elles sont respectivement mises en court-circuit l'une par rapport à l'autre au moyen d'un élément capacitif (14, 15) formé dans la structure de conducteur à fente (2) et que les éléments capacitifs sont formés dans la structure de conducteur à fente (2), en dehors de la bordure de l'espace intérieur (11) du guide d'ondes.

8. Oscillateur à guide d'ondes selon la revendication 5, caractérisé par le fait que les conducteurs à fente de compensation (6, 7) reliés ensemble sont des conducteurs à fente de longueur environ un quart de longueur d'onde et qui sont mis en court-circuit et sont disposés au centre et perpendiculairement aux vecteurs du champ électrique E du guide d'ondes qui les jouxte.

9. Tronçon de guide d'ondes selon la revendication 8, caractérisé par le fait que les conducteurs à fente de compensation (6, 7) reliés ensemble sont conçus sous forme d'écran pour le champ magnétique H.

10. Oscillateur à guide d'ondes selon la revendication 8 ou 9, caractérisé par le fait que la structure de conducteur à fente (2) présente deux conducteurs à fente rayonnante (6, 7) supplémentaires qui, par leur bord extérieur, viennent, sur toute leur longueur, en bordure de l'espace intérieur (11) du guide d'ondes et qui, en fréquence de résonance, coïncident avec la fréquence de résonance f (désignée OI) des deux premiers conducteurs à fente rayonnante (4, 5).

11. Oscillateur à guide d'ondes selon la revendication 10, caractérisé par le fait que les deux conducteurs à fente rayonnante supplémentaires (16, 17) sont reliés ensemble par leurs extrémités ouvertes et, à l'emplacement du joint, sont pontés par un élément oscillant à semiconducteur (18) qui est intégré dans la structure de conducteur à fente (2) en face de l'élément oscillant à semiconducteur (3).

12. Oscillateur à guide d'ondes selon la revendication 11, caractérisé par le fait que chacun des conducteurs à fente rayonnante (4 et 16, 5 et 17) disposés des mêmes côtés des éléments oscillants à semiconducteur (3, 18) sont mis en court-circuit l'un par rapport à l'autre par un élément capacitif (15, 16) formé dans la structure de conducteur à fente (2) et que les éléments capacitifs sont disposés à l'extérieur de la bordure de l'espace intérieur (11) du guide d'ondes.

13. Oscillateur à guide d'ondes selon la revendication 10, caractérisé par le fait que chacun des conducteurs à fente rayonnante supplémentaires (16, 17) présente à une extrémité un court-circuit en haute fréquence (19, 20) et que les extrémités, munies des courts-circuits en haute fréquence (19, 20), des conducteurs à fente rayonnante (16, 17) sont disposées en face de l'élément oscillant à semiconducteur (3).

14. Oscillateur à guide d'ondes selon la revendication 13, caractérisé par le fait que les conducteurs à fente rayonnante (4 et 16, 5 et 17) disposés des mêmes côtés de l'élément oscillant à semiconducteur (3) sont respectivement mis en court-circuit l'un par rapport à l'autre par un élément capacitif (15, 16) formé dans la structure de conducteur à fente (2) et que les éléments capacitifs sont disposés à l'extérieur de la bordure de l'espace intérieur (11) du guide d'ondes.

15. Oscillateur à guide d'ondes selon l'une des revendications 10 à 14, caractérisé par le fait que chacun des conducteurs à fente rayonnante (4, 5, 16, 17) présente une longueur électrique efficace qui correspond à une demi-longueur de l'onde fondamentale à produire dans le guide d'ondes.

16. Oscillateur à guide d'ondes selon l'une des revendications 10 à 15, caractérisé par le fait que, d'un côté de la structure de conducteur à fente (2) inséré dans le guide d'ondes (1), le guide d'ondes (1) présente un court-circuit quart d'onde et que la structure de conducteur à fente (2) envoie l'onde fondamentale de l'autre côté sur un tronçon du guide d'ondes (1) qui se poursuit.

17. Oscillateur à guide d'ondes selon l'une des revendications 1 à 16, caractérisé par le fait que la section du guide d'ondes (1) perpendiculaire à l'axe du guide d'ondes est rectangulaire.

18. Oscillateur à guide d'ondes selon l'une des revendications 1 à 16, caractérisé par le fait que la section du guide d'ondes (1) perpendiculaire à l'axe du guide d'ondes est circulaire.
